# EUROPÄISCHE PATENTSCHRIFT

(11) **EP 2 081 296 B1**
(45) Veröffentlichungstag und Bekanntmachung des Hinweises auf die Patenterteilung: **08.04.2020**
(21) Anmeldenummer: 09000536.4
(22) Anmeldetag: 16.01.2009
(51) Int. Cl.: H03K 17/96

(54) **Elektrischer Installationsschalter**
Electrical installation switch
Interrupteur d'installation électrique

(30) Priorität: 18.01.2008 DE 102008005222
(43) Veröffentlichungstag der Anmeldung: 22.07.2009
(73) Patentinhaber: Merten GmbH, 51674 Wiehl (DE)
(72) Erfinder: Kuhnert, Jürgen, 51702 Bergneustadt (DE)

(56) Entgegenhaltungen:
- EP-A1- 1 619 704
- EP-A2- 0 901 229
- WO-A1-01/85276
- DE-U1-202006 018 448
- US-A- 6 003 390
- US-A1- 2005 057 514

## Beschreibung

Die Erfindung betrifft einen elektrischen Installationsschalter nach dem Oberbegriff des Patentanspruches 1.

Elektrische Installationsschalter dienen zum Herstellen elektrischer Kontakte, um unterschiedlichste Funktionen technischer Geräte zu steuern und bestehen im Rahmen der Gebäudetechnik üblicherweise aus einem in einem ortsfesten Gehäuse installierbaren Sockel und einem frontseitig angeordneten Bedienelement. Unterschieden werden dabei einerseits elektrische Schalter, wobei eine manuelle Betätigung des Bedienelementes über mechanische Schalteinrichtungen eine elektrische Kontaktierung hervorruft, und andererseits elektronische Schalter, wobei die Betätigung des Bedienelementes elektronisch aufbereitet und verarbeitet wird und vorzugsweise elektronische Schalteinrichtungen angesteuert werden, die angeschlossene Verbraucher mit Netzspannung versorgen. Da elektronische Bauelemente nur schwache Steuerströme schalten, sind zur direkten Schaltung von Netzströmen Relais und Verstärker in adaptierbaren Gerätesockeln integriert. Derartige elektronische Schalter ermöglichen eine komplexe Ansteuerung von Verbrauchern, z. B. mittels Dimmern, Funktions- oder Zeitsteuerungen.

Aus der DE 10 2004 035 321 A1 und aus der DE 94 11 392 U1 sind beispielsweise elektronische Installationsschalter bekannt, bei denen die Betätigung eines multifunktionalen wippenartigen Bedienelementes über darunter angeordnete Mikrotaster auf eine Elektronikeinheit übertragen wird. Durch den Einsatz von Mikrotastern, die ein kleines Betätigungselement mit kurzem Schalthub aufweisen, werden im Vergleich zu konventionellen elektrischen Schaltern, z. B. Lichtschaltern, relativ flachbauende Schalter möglich.

Nachteilig ist bei diesen Lösungen, dass die Anordnung der Schaltfläche nur eine sehr begrenzte Anzahl von Bedienvarianten ermöglicht und die Schaltflächen weiterhin wesentlich über die übrigen Bauteile des Installationsschalters, beispielsweise einer Zentralplatte, einem Rahmen oder einem Gehäuse vorstehen. Allgemein besteht das Bedürfnis möglichst flache Baueinheiten zu haben, wobei insbesondere im Wohnbereich zusätzlich optisch ansprechende Lösungen erwünscht sind.

Die Aufgabe der vorliegenden Erfindung besteht deshalb darin, die vorstehend genannten Nachteile zu beseitigen und einen elektrischen Installationsschalter zu schaffen, der multifunktional und flachbauend ausgebildet ist.

Gelöst wird diese Aufgabe durch die im Patentanspruch 1 angegebenen Merkmale. Vorteilhafte Ausgestaltungen ergeben sich aus den Unteransprüchen.

Die Erfindung gemäß dem Patentanspruch 1 weist einen Installationsschalter auf, der vielfältige Bedienvarianten und Funktionalitäten ermöglicht und flachbauend ausgebildet ist, wobei ein Bedienelement weitestgehend flächenbündig zu dem umgebenden Rahmen oder Gehäuse angeordnet ist. Durch die Schaffung neuartiger Bedienstrukturen wird diese vorteilhafte und flachbauende Einheit geschaffen. Unter einem Schalter werden hier Installationsgeräte zusammengefasst, die die bekannten Funktionalitäten von mechanischen als auch elektronischen Schaltern und Tastern aufweisen.

Ein erfindungsgemäßer Schalter besteht aus einem Unterteil und aus einem an dem Unterteil schwimmend angeordneten Bedienelement. Zwischen dem Unterteil und dem Bedienelement befindet sich eine Platine, auf der Sensoren und weitere elektrische/elektronische Bauelemente, vorzugsweise ein Mikroprozessor, angeordnet sind. Für eine flächige Erfassung von Betätigungen befinden sich mindestens drei Sensoren auf der Platine, die von dem Bedienelement überdeckt werden. Die Sensoren sind Druckkraft messende Sensoren. Diese Sensoren weisen keine mechanisch schaltenden Elemente auf, so dass kein Druckpunkt überwunden werden muss und der Betätigungsweg sehr klein ist. Folglich sind die Sensoren sehr flach ausgebildet und ermöglichen einen äußerst flachbauenden Schalter.

Um eine Rückstellung des Bedienelementes in die Ausgangslage zu gewährleisten, sind zwischen dem Bedienelement und den Sensoren jeweils rückstellende Elemente angeordnet, beispielsweise Polster aus Schaumstoff. Darüber hinaus können auf der Unterseite des Bedienelementes Stege ausgebildet, um im unbetätigten Zustand einen auswertungsrelevanten Vordruck auf die Sensoren auszuüben.

Zur Realisierung der Bedienstrukturen ist das Bedienelement an dem Unterteil schwimmend gelagert, wobei hierzu komplementäre Führungsmittel ausgebildet sind, die eine senkrechte Verschiebbarkeit ermöglichen. Neben rastend ineinandergreifenden Führungsmitteln sind hierfür auch Gehäusestrukturen geeignet, die das Bedienelement senkrecht bewegbar an dem Unterteil führen.

Die Anzahl und Anordnung der Sensoren auf der Platine hängt von der Form des Schalters ab. Zwangsläufig befinden sich für eine flächige Erfassung mindestens drei Sensoren auf der Platine, die von dem Bedienelement überdeckt werden. Insbesondere für eine eckige Schalterform eignet sich die Anordnung je eines Sensors in einer Ecke. Um die Funktionalitäten und Bedienvarianten eines Schalter zu erhöhen, ist eine hinreichend empfindliche Kraftmessung erforderlich, so dass dann eine erhöhte Anzahl von Sensoren sinnvoll ist.

Druckkraft messende Sensoren ändern durch die Einwirkung einer Kraft von außen auf die aktive Oberfläche ihre spezifischen Eigenschaften. Durch den Einsatz solcher Sensoren lassen sich äußerst variable und multifunktionale Schalter realisieren, wobei die Sensorsignale hierfür in eine Druckkraft proportionale Spannung umgewandelt werden. Die Auswertung und Verarbeitung der Sensorsignale erfolgt elektronisch, wobei ein Mikroprozessor gegenüber einer Elektronikschaltung Vorteile aufweist. Durch den Mikroprozessor bzw. das entsprechende Programm lassen sich die Funktionalitäten und entsprechende Schaltparameter variabel einstellen. Der Prozessor kann hierzu extern programmiert werden. Darüber hinaus weist eine einen Mikroprozessor beinhaltende Anordnung weniger Bauteile auf als eine entsprechende elektronische Schaltung.

Das Bedienelement wird durch Druckausübung in eine spezifische Position relativ zu dem Unterteil bewegt und betätigt dadurch die Sensoren, wobei die an dem jeweiligen Sensor einwirkende Druckkraft gemessen wird und entsprechend eines Programms die Sensorsignale ausgewertet werden und eine Schaltaktion ausgeführt wird. Da das Bedienelement schwimmend gelagert ist, erfolgt keine Bewegung um ein festes Lager, sondern abhängig von der Position und dem Druck auf das Bedienelement eine Verlagerung des Bedienelementes um eine jeweils spezifische Kippachse.

Bei dem erfindungsgemäßen Schalter kann jedem Punkt eines alle Sensoren überspannenden Bedienelementes eine eigene Funktionalität zugeordnet werde. Bedingt durch die schwimmende Lagerung des Bedienelementes an dem Unterteil und damit auf den Sensoren, ruft jeder Druckpunkt auf der die Sensoren überspannenden Fläche eine spezielle Druckverteilung an den Sensoren hervor. Jeder Druckverteilung ist eine spezifische Spannungsverteilung zugeordnet, so dass mittels des Prozessors pro Druckpunkt frei definierbar Schaltaktionen zugeordnet werden können.

Neben dieser flächigen Auswertung der Krafteinwirkung auf die Punkte eines Bedienelementes können durch eine rein kraftabhängige Auswertung von Bedienpunkten über definierte Schaltschwellen in dem Mikroprozessor ebenfalls Schaltaktionen gestartet werden.

Des weiteren lässt sich auch eine ändernde Druckverteilung von einem Sensor zu einem anderen Sensor erfassen, so dass beispielsweise Dimmen oder motorische Ansteuerungen von Verbrauchern möglich sind. In einer erweiterten Ausführung kann zusätzlich die Geschwindigkeit der sich ändernden Druckverteilung erfasst und auf die auszuführende Schaltaktion übertragen werden oder beispielsweise zum Schutz der angeschlossenen Verbraucher begrenzt werden.

Die Definition und Verwendung von Schaltpunkten und zugeordneten Schaltaktionen ist äußerst variabel. Aus Gründen der Handhabung und der technischen Differenzierung ist ein hinreichender Abstand zwischen den Schaltpunkten notwendig. Vorteilhafterweise bietet sich eine rasterartige Verteilung von Schaltpunkten auf dem Bedienelement an.

Das Bedienelement spannt sich über allen Sensoren flächig auf und hat bevorzugterweise die bekannt flächige Form einer Tast/Schalter oder Sensorfläche. In einer besonderen Ausgestaltung kann ein Bedienelement zusätzlich einen Fortsatz aufweisen, um bekannte Schiebe-, Kipp- sowie Drehmechanismen oder einen Joystick zu imitieren.

Mit dem erfindungsgemäßen Schalter sind umfangreiche Funktionen möglich. Es können mehrere Verbraucher unabhängig voneinander geschaltet werden. In einer Betätigungsart kann z. B. Licht ein- und ausgeschaltet oder Jalousien herauf- oder heruntergefahren werden, wobei hierfür senkrecht, waagerecht oder diagonal gegenüberliegende Sensorpaare oder auch durch Mehrfachbetätigung des gleichen Sensors die Funktionen definiert werden können. Darüber hinaus sind weitere Funktionen z. B das Anwählen bestimmter Lichtquellen oder die Verstellung des Winkels der Lamellen von Jalousien möglich.

Darüber hinaus sind komplexe Funktionen über Mehrfach- oder kombinatorische Betätigungen möglich. Ein gleitendes Betätigen gegenüberliegender Sensoren ruft eine gegenproportionale Druckveränderung an den Sensoren hervor und kann beispielsweise zur Steuerung eines Dimmers benutzt werden. Hierdurch lassen sich bisherige Kipp- und Schiebeschalter ersetzen bzw. kombinieren.

Definierte Druckkräfte an den Sensoren können beispielsweise genutzt werden, um druckabhängige Schaltschwellen im Sinne einer Zugangscodierung oder im Sinne einer Kindersicherung zu ermöglichen. So sind auch mehrere Schaltschwellen an einem Sensor denkbar.

In weiterer Ausgestaltung weist das Bedienelement eine Betätigungsart auf, bei der es, vorzugsweise mittig, gedrückt wird und die zugeführte Kraft auf mehrere Sensoren aufgeteilt wird. Diese zentrale Funktion wird vorzugsweise genutzt, um einen definierten Ausgangszustand anzuwählen.

Entsprechende Sensoren, beispielsweise sogenannte kraftabhängige Widerstände, ändern durch die Einwirkung einer Kraft von außen auf die aktive Oberfläche ihren Widerstand. Je höher die auf den Sensor einwirkende Kraft ist, desto niedriger ist der Widerstand. Bei einer Nichtbetätigung des Sensors ist der Widerstand sehr hochohmig.

Bei einem ersten Sensortyp werden durch die Einwirkung einer Kraft eine obere und eine untere Elektrode des Sensors auf eine Sensorfläche gedrückt. Die Sensorfläche besteht aus leitenden und nicht leitenden Partikeln, die abhängig von der wirkenden Kraft mehr oder weniger verdichtet werden und dementsprechend eine Widerstandsänderung des Sensors hervorrufen.

Ein zweiter Sensortyp weist flächenmäßig beabstandete Kontaktstrukturen auf, wobei zwischen einzelnen Kontaktfingern Widerstandsbrücken bestehen. Durch das Zuführen einer Kraft wird eine Kontaktschicht auf die flächenmäßig beabstandeten Kontaktstrukturen gedrückt und der Widerstand des Sensors verändert. Je höher die eingeleitete Kraft ist, desto mehr Widerstandsbrücken werden geschlossen und parallel geschaltet.

Weitere Druckkraft messende Sensoren sind kapazitive Drucksensoren, die einen in einen Siliziumchip eindiffundierten Kondensator enthalten. Über eine Membran wird bei Druckbeaufschlagung der Abstand der Kondensatorplatten, und dadurch die Kapazität des Kondensators, verändert. Darüber hinaus gibt es auch piezo-elektrisch wirkende Drucksensoren.

Vorteilhafterweise weist der Schalter einen Vorsatz für eine Wanddose auf. Z. B. kann das Unterteil als ein solcher Vorsatz ausgebildet sein oder mit einem solchen verbunden sein. Auf diese Weise könnte der Schalter als herkömmlicher Lichtschalter eingesetzt werden. Die Sensoren können schwache Steuerströme schalten. Gleichwohl ist durch eine Verwendung von Relais oder Verstärken eine direkte Schaltung von Netzströmen denkbar. Praktischerweise existieren deshalb unterschiedlich ausgestattete Schalter, die je nach Anwendungsfall einsetzbar sind.

In einer besonders vorteilhaften Ausführung lassen sich die Schalter durch entsprechend gestaltete Bedienelemente nahtlos an die Oberflächen der Umgebung anpassen und damit integrieren. Denkbar sind auch informative Beschriftungen und Bedruckungen der Bedienelemente.

Es wird ein universell verwendbarer Installationsschalter geschaffen, mit dem im Bedarfsfall bestehende Installationsgeräte umgerüstet werden können. Wesentlich ist dabei, dass zur Aufrüstung des Installationsgerätes lediglich das gerätespezifische Frontelement ausgetauscht werden muss. Eine Demontage des Gerätesockels bzw. des Tragrahmens ist nicht notwendig. Die vorhandene Geometrie der Gerätesockel kann unverändert genutzt werden, da die Befestigungspunkte und Kontaktpunkte erhalten bleiben.

Weitere Einzelheiten, Merkmale und Vorteile der Erfindung ergeben sich aus nachfolgender Beschreibung eines bevorzugten Ausführungsbeispieles anhand der Zeichnungen.

Es zeigen:

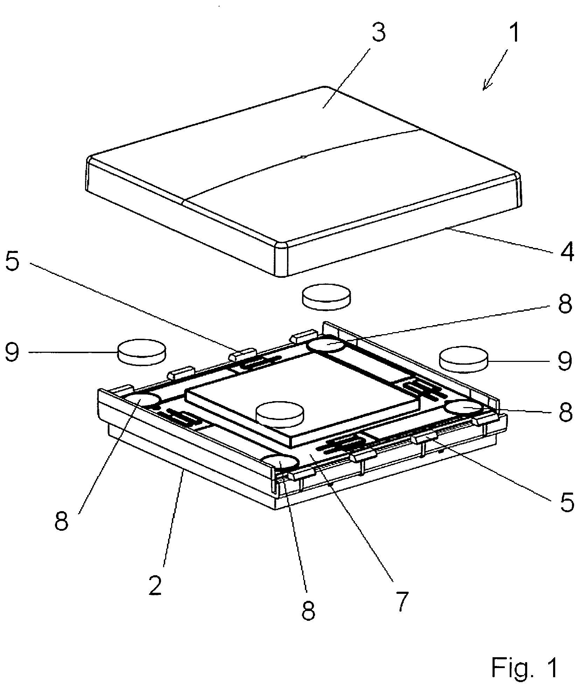

- Figur 1: einen schematischen Aufbau eines Installationsschalters in einer Explosionsansicht.

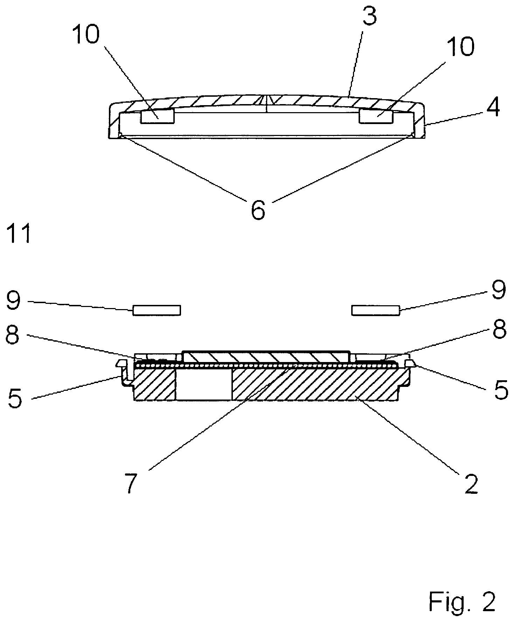

- Figur 2: einen Querschnitt durch einen Installationsschalter gemäß Figur 1 im demontierten Zustand.

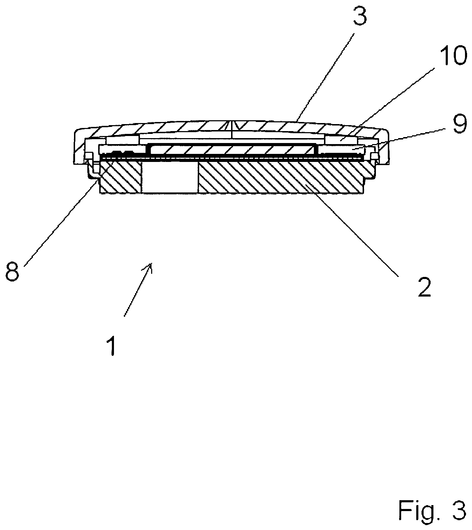

- Figur 3: einen Querschnitt durch einen Installationsschalter im montierten Zustand.

Gleiche oder gleichwirkende Bauteile sind in der nachfolgenden Beschreibung mit gleichen Bezugszeichen versehen.

Nachfolgend wird der Aufbau und die Funktionsweise des erfindungsgemäßen Installationsschalters 1 näher beschrieben, der beispielsweise als Vorsatz für ein nicht dargestelltes Installationsgerät verwendet werden kann.

Der Schalter 1 besteht aus einem Unterteil 2 und einem Bedienelement 3. Das Unterteil 2 ist als quadratische Platte ausgebildet und entspricht in seinen Abmessungen den Abmessungen eines elektrischen Installationsgerätes. Das Bedienelement 3 besteht aus einer quadratischen Platte, die etwas größer ist als die des Unterteils 2, wobei ein aufstehender Umfangsrand 4 des Bedienelementes 3 das Unterteil 2 flächenmäßig und höhenmäßig umgibt. Das Bedienelement 3 ist an dem Unterteil 2 schwimmend geführt, da kein Festlager vorhanden ist. Um das Bedienelement 3 an dem Unterteil 2 zu fixieren, sind an dem Unterteil 2 umfangsseitig Rastnasen 5 angeordnet, die innenseitig des Umfangsrandes 4 des Bedienelementes 3 ausgebildete Rasten 6 hintergreifen.

In das Unterteil 2 ist eine quadratische Platine 7 eingesetzt, auf der in jeder Ecke ein Schaltelement 8 in Form eines Druckkraft messenden Sensors angeordnet ist. Zusätzlich ist jedem Sensor 8 ein rückstellendes Element 9, z. B. ein Polster aus Schaumstoff, zugeordnet, das zwischen Sensor 8 und Bedienelement 3 angeordnet ist. An der Unterseite des Bedienelementes 3 sind in den Ecken Stege 10 angeformt, die über den rückstellenden Elementen 9 bzw. Sensoren 8 liegen. Auf der Platine 7 befindet sich des weiteren eine Elektronikeinheit 11, in der ein Mikroprozessor und verschiedene elektrische/elektronische Bauelemente angeordnet sind, die die Auswertung von Sensorsignalen, beispielsweise von elektrischen Widerständen oder Kapazitäten, und die Umsetzung in Schaltsignale zur Herstellung eines elektrischen Kontaktes realisiert.

Durch eine Betätigung des Bedienelementes 3 werden die Sensoren 8 belastet, wobei die auf die Sensoren 8 wirkende Druckkraft, deren Verteilung und/oder Verteilungsänderung erfasst wird und entsprechend des Auswerteprogramms der Elektronikeinheit 11 eine Schaltaktion ausgeführt wird. Da je Druckpunkt der die Sensoren 8 überspannenden Fläche eine spezifische Druckkraftbelastung an den Sensoren 8 hervorgerufen wird, sind pro Druckpunkt auf dem Bedienelement 3 frei definierbar Schaltaktionen zuordenbar. Aus Gründen der Handhabung und der technischen Differenzierung ist ein hinreichender Abstand bei der Festlegung nutzbarer Druckpunkte notwendig. Vorteilhafterweise bietet sich eine rasterartige Verteilung der Druckpunkte auf dem Bedienelement 3 an.

In der Elektronikeinheit 11 werden die auf die Sensoren 8 einwirkenden Druckkräfte in proportionale Spannungen umgewandelt. Die Auswertung und Verarbeitung dieser Signale erfolgt elektronisch. Vorzugsweise durch einen Mikroprozessor bzw. entsprechende Programme lassen sich die Funktionalitäten und entsprechende Schaltparameter variabel einstellen. Der Prozessor kann hierzu extern programmiert werden, beispielsweise mittels eines USB-Programmiertools.

Vorteilhafterweise ist der Schalter 1 als Vorsatz für ein Installationsgerät ausgebildet. Auf diese Weise können bestehende Installationsgeräte ersetzt oder aufgerüstet werden. Da die Sensoren 8 nur schwache Steuerströme schalten, ist durch eine Verwendung von Relais, Transistoren oder Verstärken in adaptierbaren Geräte eine direkte Schaltung von Netzströmen möglich. Praktischerweise existieren deshalb unterschiedlich ausgestattete Geräte, die je nach Anwendungsfall einsetzbar sind.

Die vorstehende Beschreibung des Ausführungsbeispieles dient nur zu illustrativen Zwecken und nicht zum Zwecke der Beschränkung der Erfindung. Im Rahmen der Erfindung sind verschiedene Änderungen und Modifikationen möglich, ohne den Umfang der Erfindung sowie ihrer Äquivalente zu verlassen.

### Bezugszeichenliste

- 1: Installationsschalter
- 2: Unterteil
- 3: Bedienelement
- 4: Umfangsrand
- 5: Rastnase
- 6: Raste
- 7: Platine
- 8: Schaltelement, Sensor
- 9: rückstellendes Element
- 10: Steg
- 11: Elektronikeinheit

## Patentansprüche

1. Elektrisches Installationsgerät bestehend aus einem in einem Gehäuse installierbaren Gerätesockel und aus einem an der Frontseite des Gerätesockels montierbaren elektrischen Installationsschalter (1) bestehend aus einem Unterteil (2) und aus einem relativ zum Unterteil (2) bewegbaren Bedienelement (3), wobei das Unterteil (2) mehrere von dem Bedienelement (3) zu betätigende Schaltelemente (8) zum Herstellen eines elektrischen Kontaktes und weitere elektrische Bauteile aufweist, wobei die Schaltelemente (8) Druckkraft messende Sensoren sind und das Bedienelement (3) schwimmend auf dem Unterteil (2) angeordnet ist, **dadurch gekennzeichnet, dass** über variable Einstellung der Schaltparameter der Sensoren und die flächige Auswertung der Krafteinwirkung auf die Sensoren frei definierbare Schaltaktionen zugeordnet werden können.

2. Elektrisches Installationsgerät nach Patentanspruch 1, **dadurch gekennzeichnet, dass** die Sensoren (8) kraftabhängige Widerstände sind.

3. Elektrisches Installationsgerät nach Patentanspruch 2, **dadurch gekennzeichnet, dass** der Widerstand der Sensoren (8) durch kraftabhängige Verdichtung von leitenden Partikeln veränderbar ist.

4. Elektrisches Installationsgerät nach einem der Patentansprüche 2 oder 3, **dadurch gekennzeichnet, dass** der Widerstand der Sensoren (8) durch kraftabhängige Verbindung von flächenmäßigen Kontaktstrukturen veränderbar ist.

5. Elektrisches Installationsgerät nach Patentanspruch 1, **dadurch gekennzeichnet, dass** die Sensoren (8) kraftabhängige Kapazitäten sind.

6. Elektrisches Installationsgerät nach einem der vorhergehenden Patentansprüche, **dadurch gekennzeichnet, dass** die Auswertung und Verarbeitung von auf die Sensoren (8) einwirkenden Druckkräfte über einen Prozessor und/oder über eine Elektronikeinheit (11) erfolgt.

7. Elektrisches Installationsgerät nach einem der vorhergehenden Patentansprüche, **dadurch gekennzeichnet, dass** die auf die Sensoren (8) einwirkende Druckkräfte in proportionale Spannungen umgewandelt werden.

8. Elektrisches Installationsgerät nach einem der vorhergehenden Patentansprüche, **dadurch gekennzeichnet, dass** die auf einen Sensor (8) einwirkende Druckkraft ausgewertet wird und zur Herstellung eines elektrischen Kontaktes dient.

9. Elektrisches Installationsgerät nach einem der vorhergehenden Patentansprüche, **dadurch gekennzeichnet, dass** eine Verteilung der auf allen Sensoren (8) einwirkenden Druckkräfte ausgewertet wird und zur Herstellung eines elektrischen Kontaktes dient.

10. Elektrisches Installationsgerät nach einem der vorhergehenden Patentansprüche, **dadurch gekennzeichnet, dass** eine Änderung der Verteilung der auf Sensoren (8) einwirkenden Druckkräfte ausgewertet wird und zur Herstellung eines elektrischen Kontaktes dient.

11. Elektrisches Installationsgerät nach einem der vorhergehenden Patentansprüche, **dadurch gekennzeichnet, dass** eine Geschwindigkeit der Änderung der Verteilung der auf Sensoren (8) einwirkenden Druckkräfte ausgewertet wird und zur Herstellung eines elektrischen Kontaktes dient.

12. Elektrisches Installationsgerät nach einem der vorhergehenden Patentansprüche, **dadurch gekennzeichnet, dass** Bedienfunktionen des Installationsschalters (1) variabel einstellbar sind.

13. Elektrisches Installationsgerät nach einem der vorhergehenden Patentansprüche, **dadurch gekennzeichnet, dass** mindestens drei Sensoren (8) flächig unter dem Bedienelement (3) angeordnet sind.

14. Elektrisches Installationsgerät nach einem der vorhergehenden Patentansprüche, **dadurch gekennzeichnet, dass** das Bedienelement (3) einen vorstehenden Fortsatz aufweist.

15. Elektrisches Installationsgerät nach einem der vorhergehenden Patentansprüche, **dadurch gekennzeichnet, dass** das Bedienelement (3) mittels komplementärer Führungsmittel an dem Unterteil (2) gelagert ist.

16. Elektrisches Installationsgerät nach einem der vorhergehenden Patentansprüche, **dadurch gekennzeichnet, dass** zwischen den Sensoren (8) und dem Bedienelement (3) rückstellende Elemente (9) angeordnet sind.

## Claims

1. Electrical installation device comprising a device base installable in a housing and an electrical installation switch (1) mountable on the front side of the device base and comprising a lower part (2) and an operating element (3) movable relative to the lower part (2), wherein the lower part (2) has a plurality of switching elements (8) for producing a electrical contact, which switching elements are to be actuated by the operating element (3), and further electrical components, wherein the switching elements (8) are sensors that measure pressure force, and the operating element (3) is arranged on the lower part (2) in a floating manner, **characterized in that** freely definable switching actions can be assigned by way of variable setting of the switching parameters of the sensors and the areal evaluation of the action of force on the sensors.

2. Electrical installation device according to Patent Claim 1, **characterized in that** the sensors (8) are force-dependent resistors.

3. Electrical installation device according to Patent Claim 2, **characterized in that** the resistance of the sensors (8) is variable by force-dependent compression of conductive particles.

4. Electrical installation device according to either of Patent Claims 2 and 3, **characterized in that** the resistance of the sensors (8) is variable by force-dependent connection of planar contact structures.

5. Electrical installation device according to Patent Claim 1, **characterized in that** the sensors (8) are force-dependent capacitances.

6. Electrical installation device according to according to any of the preceding patent claims, **characterized in that** the pressure forces acting on the sensors (8) are evaluated and processed by way of a processor and/or by way of an electronic unit (11).

7. Electrical installation device according to according to any of the preceding patent claims, **characterized in that** the pressure forces acting on the sensors (8) are converted into proportional voltages.

8. Electrical installation device according to according to any of the preceding patent claims, **characterized in that** the pressure force acting on a sensor (8) is evaluated and serves for producing an electrical contact.

9. Electrical installation device according to according to any of the preceding patent claims, **characterized in that** a distribution of the pressure forces acting on all the sensors (8) is evaluated and serves for producing an electrical contact.

10. Electrical installation device according to according to any of the preceding patent claims, **characterized in that** a change in the distribution of the pressure forces acting on sensors (8) is evaluated and serves for producing an electrical contact.

11. Electrical installation device according to according to any of the preceding patent claims, **characterized in that** a rate of the change in the distribution of the pressure forces acting on sensors (8) is evaluated and serves for producing an electrical contact.

12. Electrical installation device according to according to any of the preceding patent claims, **characterized in that** operating functions of the installation switch (1) are settable in a variable manner.

13. Electrical installation device according to according to any of the preceding patent claims, **characterized in that** at least three sensors (8) are arranged areally below the operating element (3).

14. Electrical installation device according to according to any of the preceding patent claims, **characterized in that** the operating element (3) has a projecting extension.

15. Electrical installation device according to according to any of the preceding patent claims, **characterized in that** the operating element (3) is mounted by means of complementary guide means on the lower part (2).

16. Electrical installation device according to according to any of the preceding patent claims, **characterized in that** restoring elements (9) are arranged between the sensors (8) and the operating element (3).

## Revendications

1. Dispositif d'installation électrique comprenant une base de dispositif qui peut être installée dans un boîtier et un interrupteur d'installation électrique (1) qui peut être monté sur le côté avant de la base de dispositif et qui comprend une partie inférieure (2) et un élément de commande (3) qui peut être déplacé par rapport à la partie inférieure (2), la partie inférieure (2) comportant une pluralité d'éléments de commutation (8) devant être actionnés par l'élément de commande (3) et destinés à réaliser un contact électrique et d'autres composants électriques, les éléments de commutation (8) étant des capteurs de mesure de force de pression et l'élément de commande (3) étant disposé de manière flottante sur la partie inférieure (2), **caractérisé en ce que** des actions de commutation librement définissables peuvent être associées par réglage variable de paramètres de commutation des capteurs et évaluation sensiblement bidimensionnelle de la force exercée sur les capteurs.

2. Dispositif d'installation électrique selon la revendication 1, **caractérisé en ce que** les capteurs (8) sont des résistances qui dépendent de la force.

3. Dispositif d'installation électrique selon la revendication 2, **caractérisé en ce que** la résistance des capteurs (8) peut être modifiée par une compression des particules conductrices qui dépend de la force.

4. Dispositif d'installation électrique selon l'une des revendications 2 et 3, **caractérisé en ce que** la résistance des capteurs (8) peut être modifiée par une liaison de structures de contact surfaciques qui dépend de la force.

5. Dispositif d'installation électrique selon la revendication 1, **caractérisé en ce que** les capteurs (8) sont des capacités qui dépendent de la force.

6. Dispositif d'installation électrique selon l'une des revendications précédentes, **caractérisé en ce que** l'évaluation et le traitement des forces de pression exercées sur les capteurs (8) sont effectués par le biais d'un processeur et/ou d'une unité électronique (11) .

7. Dispositif d'installation électrique selon l'une des revendications précédentes, **caractérisé en ce que** les forces de pression exercées sur les capteurs (8) sont converties en tensions proportionnelles.

8. Dispositif d'installation électrique selon l'une des revendications précédentes, **caractérisé en ce que** la force de pression exercée sur un capteur (8) est évaluée et utilisée pour réaliser un contact électrique.

9. Dispositif d'installation électrique selon l'une des revendications précédentes, **caractérisé en ce qu'**une répartition des forces de pression exercées sur tous les capteurs (8) est évaluée et utilisée pour réaliser un contact électrique.

10. Dispositif d'installation électrique selon l'une des revendications précédentes, **caractérisé en ce qu'**une variation de la répartition des forces de pression exercées sur les capteurs (8) est évaluée et utilisée pour réaliser un contact électrique.

11. Dispositif d'installation électrique selon l'une des revendications précédentes, **caractérisé en ce qu'**une vitesse de variation de la répartition des forces de pression exercées sur les capteurs (8) est évaluée et utilisée pour réaliser un contact électrique.

12. Dispositif d'installation électrique selon l'une des revendications précédentes, **caractérisé en ce que** les fonctions de commande de l'interrupteur d'installation (1) sont réglables de manière variable.

13. Dispositif d'installation électrique selon l'une des revendications précédentes, **caractérisé en ce qu'**au moins trois capteurs (8) sont disposés de manière sensiblement bidimensionnelle sous l'élément de commande (3).

14. Dispositif d'installation électrique selon l'une des revendications précédentes, **caractérisé en ce que** l'élément de commande (3) présente une extension en saillie.

15. Dispositif d'installation électrique selon l'une des revendications précédentes, **caractérisé en ce que** l'élément de commande (3) est monté sur la partie inférieure (2) à l'aide de moyens de guidage complémentaires.

16. Dispositif d'installation électrique selon l'une des revendications précédentes, **caractérisé en ce que** des éléments de rappel (9) sont disposés entre les capteurs (8) et l'élément de commande (3).
